# EUROPEAN PATENT APPLICATION

(11) **EP 2 787 548 A1**
(43) Date of publication of application: **08.10.2014**
(21) Application number: 11876608.8
(22) Date of filing: 28.11.2011
(51) Int. Cl.: H01L 51/50, H01L 51/52, H01L 51/54, H01L 51/56

(54) **ORGANIC ELECTROLUMINESCENT DEVICE HAVING TERNARY DOPED HOLE TRANSPORTATION LAYER AND PREPARATION METHOD THEREFOR**

(71) Applicant: Ocean's King Lighting Science & Technology Co., Ltd., Guangdong 518054 (CN); Shenzhen Ocean's King Lighting Engineering Co. Ltd., Guangdong 518100 (CN)
(72) Inventor: ZHOU, Mingjie, Shenzhen Guangdong 518054 (CN); WANG, Ping, Shenzhen Guangdong 518054 (CN); HUANG, Hui, Shenzhen Guangdong 518054 (CN); CHEN, Jixing, Shenzhen Guangdong 518054 (CN)
(74) Representative: Lenthall, Joseph
(86) International application number: PCT/CN2011/083053
(87) International publication number: WO 2013/078595

(57) **Abstract**

Disclosed are an organic electroluminescent device having ternary doped hole transportation layer and a preparation method therefor. The electroluminescent device comprises a conductive anode substrate (1), a ternary doped hole transportation layer (2), a light-emitting layer (3), an electron transportation layer (4), an electron injecting layer (5) and a cathode layer (6), wherein the material for the ternary doped hole transportation layer (2) is a mixed material made by doping a cerium salt and a hole transportation material into a metal compound. The electroluminescent device forms p-doping by doping the cerium salt and the hold transportation material into the metal compound, which improves the ability of injecting and transporting holes, and increases the efficiency of light emission. Since the material for the ternary doped hole transportation layer (2) is predominately a metal compound, the process difficulty and manufacturing costs are reduced, facilitating industrial production and commercial applications.

## Description

### FIELD OF THE INVENTION

The present invention relates to the field of organic electroluminescence, more particularly to organic electroluminescent device having ternary doped hole transportation layer and preparation method therefor.

### BACKGROUND OF THE INVENTION

In 1987, C.W. Tang and Van Slyke in Eastman Kodak, an American company, reported a breakthrough in the search for organic electroluminescence. They prepared double-layer organic electroluminescent device having high luminance and high efficiency by ultra-thin film technique. In such double-layer device, the luminance can reach 1000 cd/m² at 10V, and efficiency of light emission is 1.51 lm/W. The device lifetime is more than 100 hours.

Organic electroluminescent device works on the principle that: in the case of applied external field, electrons are injected from the cathode into the lowest unoccupied molecular orbital (LUMO) of organics, while holes are injected from the anode into highest occupied molecular orbital (HOMO) of organics. The electrons and the holes move towards each other and they recombine forming excitons in light-emitting layer. Such excitons migrate in the electric field, and energy transfer to light-emitting material. Electrons are excited and jump from the ground state to an excited state. The decay of this excited state results in a radiative relaxation of the energy levels of the electron, accompanied by release of the energy as photon.

Efficiency of light emission can be improved by increasing carriers injecting and transportation rate to achieve a larger probability of recombining of excitons. The method for increasing carriers injecting and transportation rate commonly used these days is to dope a tiny amount of p-type material (such as MoO₃, F4-TCNQ, 1-TANA, 2-TANA) into hole transportation material (m-MTDATA, NPB).However, in such method, mass percentage of the dopant p-type material is normally required in the range of 0.5-2%, which is an extremely small amount, so the doping process is hard to control. In addition, it makes the preparation more complex that one more hole injecting layer is often independently vapor deposited with the purpose of improving hole injection.

### SUMMARY OF THE INVENTION

In order to solve the problem previously existent in the prior art, the present invention provides a organic electroluminescent device having ternary doped hole transportation layer, and preparation method therefor. The invention forms p-doping by doping cesium salt and hole transportation material into metal compound to improve the ability of injecting and transporting holes, thereby increasing the efficiency of light emission. Further, the ternary doped hole transportation layer is predominately a metal compound. The process difficulty and manufacturing costs are reduced, facilitating industrial production and commercial applications in the future.

One aspect of the present invention is to provide organic electroluminescent device having ternary doped hole transportation layer, comprising conductive anode substrate, ternary doped hole transportation layer, light-emitting layer, electron transportation layer, electron injecting layer and cathode layer stacked in sequence, wherein material for the ternary doped hole transportation layer is a mixed material made by doping cerium salt and hole transportation material into metal compound.

Conductive anode substrate can be conductive glass substrate selected from indium tin oxide glass (ITO), fluorine doped tin oxide glass (FTO), aluminium doped zinc oxide (AZO) and indium doped zinc oxide (IZO).

Material for ternary doped hole transportation layer is a mixed material predominantly comprising metal compound. The mixed material is formed by doping cesium salt and hole transportation material into metal compound. Ternary doped hole transportation layer can be prepared as follows: doping cesium salt and hole transportation material into metal compound to form mixed material by e-beam deposition. Ternary doped hole transportation layer is deposited on the conductive anode substrate.

Preferably, metal compound is metallic oxide (such as, zinc oxide (ZnO) or titanium dioxide (TiO₂)) or metallic sulfide (such as, zinc sulfide (ZnS) or lead sulfide (PbS)).

Preferably, cerium salt is cesium azide (CsN₃), cesium fluoride (CsF), cesium carbonate (Cs₂CO₃) or cesium oxide (Cs₂O). Preferably, doping percentage of the cerium salt is in the range of 1 wt%-5 wt%.

Preferably, hole transportation material is 1,1-bis[4-(N,N-di(p-tolyl)amino)phenyl] cyclohexane (TAPC), N,N'-bis(3-methylphenyl)-N,N'-diphenyl-4,4'-benzidine (TPD), 4,4',4"-tris(carbazol-9-yl)-triphenylamine (TCTA) or N,N'-di-[(1-naphthalenyl)- N,N'-diphenyl]-(4.4'-biphenyl)- 4,4'- diamine (NPB). Preferably, doping percentage of the hole transportation material is in the range of 10 wt%-40 wt%.

Preferably, thickness of the ternary doped hole transportation layer is in the range of 20-60nm.

In the material of ternary doped hole transportation layer, metal compound can increase the work-function, and decrease hole injecting barrier. P-doping formed by doping cesium salt is of benefit to hole injection and transportation. The doped hole transportation material can further increase hole transportation rate and film quality (small organic molecules have relatively good film-forming properties), thereby increasing the probability of recombining of excitons in light-emitting layer.

Compared with the prior art that doping p-type material in a tiny amount (doping percentage is 0.5%-2%) into hole transportation material, the ternary doped hole transportation layer of the present invention is predominantly a metal compound. The process difficulty and manufacturing costs are reduced, facilitating industrial production and commercial applications in the future.

Light-emitting layer is deposited on the ternary doped hole transportation layer.

Preferably, material for light-emitting layer is at least one of 4-(dicyanomethylene)-2-tert-butyl-6-(1,1,7,7-tetramethyljulolidin-9-yl-vinyl)-4h-pyran (DCJTB), tris(8-hydroxyquinolinato)aluminium (Alq₃), bis(4,6-difluorophenylpyridinato-N,C2) picolinatoiridium (FIrpic), bis(4,6-difluorophenyridinato)tetrakis(1-pyrazolyl)borate iridium (FIr6), bis(2-methyldibenzo[f,h]quinoxaline) (acetylacetonate) iridium (Ir(MDQ)₂(acac)) and tris(2-phenylpyridine)iridium. More preferably, material for light-emitting layer is tris(8-hydroxyquinolinato)aluminium.

Preferably, material for light-emitting layer is a mixed material comprising host material and guest material, the host material is doped with guest material, and doping percentage of guest material is in the range of 1 wt%-20 wt%.

Guest material for light-emitting layer is 4-(dicyanomethylene)-2-tert-butyl-6-(1,1,7,7-tetramethyljulolidin-9-yl-vinyl)-4h-pyran, tris(8-hydroxyquinolinato)aluminium, bis(4,6-difluorophenylpyridinato-N,C2)picolinatoiridium, bis(4,6-difluorophenyridinato) tetrakis (1-pyrazolyl)borate iridium, bis(2-methyldibenzo[f,h]quinoxaline) (acetylacetonate) iridium or tris(2-phenylpyridine)iridium.

Host material for light-emitting layer is one or two of 1,1-bis[4-(N,N-di(p-tolyl)amino)phenyl]cyclohexane (TAPC), N,N'-bis(3-methylphenyl)-N,N'-diphenyl-4,4'-benzidine (TPD), 4,4',4"-tris(carbazol-9-yl)-triphenylamine (TCTA), N,N'-di-[(1-naphthalenyl)-N,N'-diphenyl]- (4.4'-biphenyl)- 4,4'- diamine (NPB), 2-(4-tert-butylphenyl)-5-(4-biphenyl)-1,3,4-oxadiazole (PBD), tris(8-hydroxyquinolinato) aluminium (Alq3), 4,7-diphenyl-1,10-phenanthroline (Bphen), 1,2,4-triazole derivatives (such as TAZ) and N-phenyl benzimidazole (TPBI).

Preferably, thickness of light-emitting layer is in the range of 2-50nm. More preferably, thickness of light-emitting layer is 20nm.

Electron transportation layer is deposited on the light-emitting layer. Preferably, material for electron transportation layer is 2-(4-tert-butylphenyl)-5-(4-biphenyl)-1,3,4-oxadiazole (PBD), tris(8-hydroxyquinolinato) aluminium (Alq₃), 4,7-diphenyl-1,10-phenanthroline (Bphen), 1,2,4-triazole derivatives (such as TAZ) or N-phenyl benzimidazole (TPBI). More preferably, material for electron transportation layer is 4,7-diphenyl-1,10-phenanthroline.

Preferably, thickness of electron transportation layer is in the range of 40-80nm.More preferably, thickness of electron transportation layer is 60nm.

Preferably, material for electron injecting layer is LiF, CaF₂ or NaF. More preferably, electron injecting layer is LiF.

Preferably, thickness of electron injecting layer is in the range of 0.5-5nm.More preferably, thickness of electron injecting layer is 0.7nm.

Preferably, material for cathode layer is silver (Ag), aluminium (Al), platinum (Pt) or gold (Au). More preferably, cathode layer is aluminium.

Preferably, thickness of cathode layer is in the range of 80-250nm. More preferably, thickness of cathode layer is 150nm.

Another aspect of the present invention is to provide method for preparing organic electroluminescent device having ternary doped hole transportation layer, which comprises the following steps:
(1) ultrasonically cleaning conductive anode substrate, then treating the conductive anode substrate with oxygen plasma;
(2) vapor depositing ternary doped hole transportation layer on the surface of the oxygen plasma-treated conductive anode substrate by e-beam deposition, wherein material for the ternary doped hole transportation layer is a mixed material made by doping cerium salt and hole transportation material into metal compound;
(3) vapor depositing light-emitting layer, electron transportation layer, electron injecting layer and cathode layer successively on the surface of the ternary doped hole transportation layer; and
the organic electroluminescent device is obtained after completion of the above process.

In step (1), organic pollutant on the surface of conductive anode substrate can be removed by ultrasonically cleaning.

Conductive anode substrate can be conductive glass substrate selected from indium tin oxide glass (ITO), fluorine doped tin oxide glass (FTO), aluminium doped zinc oxide (AZO) and indium doped zinc oxide (IZO).

Preferably, conductive anode substrate is ultrasonically cleaned successively with detergent, deionized water, acetone, ethanol and isopropanol for 15 min.

After cleaning, the conductive anode substrate is treated with oxygen plasma. Preferably, the oxygen plasma treatment is carried out for 5-15 min at a power of from 10W to 50W.

In step (2), ternary doped hole transportation layer is deposited on the surface of the oxygen plasma-treated conductive anode substrate by e-beam deposition.

Ternary doped hole transportation layer is a mixed material predominantly comprising metal compound. The mixed material is formed by doping cesium salt and hole transportation material into metal compound.

Preferably, metal compound is metallic oxide (such as, zinc oxide (ZnO) or titanium dioxide (TiO₂)) or metallic sulfide (such as, zinc sulfide (ZnS) or lead sulfide (PbS)).

Preferably, cerium salt is cesium azide (CsN₃), cesium fluoride (CsF), cesium carbonate (Cs₂CO₃) or cesium oxide (Cs₂O). Preferably, doping mass percentage of the cerium salt is in the range of 1%-5%.

Preferably, hole transportation material is 1,1-bis[4-(N,N-di(p-tolyl)amino)phenyl] cyclohexane (TAPC), N,N'-bis(3-methylphenyl)-N,N'-diphenyl-4,4'-benzidine (TPD), 4,4',4"-tris(carbazol-9-yl)-triphenylamine (TCTA) or N,N'-di-[(1-naphthalenyl)-N,N'-diphenyl]- (4.4'-biphenyl)- 4,4'- diamine (NPB). Preferably, doping percentage of the hole transportation material is in the range of 10 wt%-40 wt%.

Preferably, thickness of the ternary doped hole transportation layer is in the range of 20-60nm.

In the material of ternary doped hole transportation layer, metal compound can increase the work-function, and decrease hole injecting barrier. P-doping formed by doping cesium salt is of benefit to hole injection and transportation. The doped hole transportation material can further increase hole transportation rate and film quality (small organic molecules have relatively good film-forming properties), thereby increasing the probability of recombining of excitons in light-emitting layer.

Compared with the prior art that doping p-type material in a tiny amount (doping percentage is 0.5%-2%) into hole transportation material, the ternary doped hole transportation layer of the present invention is predominantly a metal compound. The process difficulty and manufacturing costs are reduced, facilitating industrial production and commercial applications in the future.

In step (3), light-emitting layer, electron transportation layer, electron injecting layer and cathode layer are successively vapor deposited to obtain the desire organic electroluminescent device.

Light-emitting layer is deposited on the ternary doped hole transportation layer.

Preferably, material for light-emitting layer is at least one of 4-(dicyanomethylene)-2-tert-butyl-6-(1,1,7,7-tetramethyljulolidin-9-yl-vinyl)-4h-pyran (DCJTB), tris(8-hydroxyquinolinato)aluminium (Alq₃), bis(4,6-difluorophenylpyridinato-N,C2)picolinatoiridium (FIrpic), bis(4,6-difluorophenyridinato)tetrakis(1-pyrazolyl)borate iridium (FIr6), bis(2-methyldibenzo[f,h]quinoxaline) (acetylacetonate) iridium (Ir(MDQ)₂(acac)) and tris(2-phenylpyridine)iridium. More preferably, material for light-emitting layer is tris(8-hydroxyquinolinato)aluminium.

Preferably, material for light-emitting layer is a mixed material comprising host material and guest material, the host material is doped with guest material, and doping percentage of guest material is in the range of 1 wt%-20 wt%.

Guest material for light-emitting layer is 4-(dicyanomethylene)-2-tert-butyl-6-(1,1,7,7-tetramethyljulolidin-9-yl-vinyl)-4h-pyran, tris(8-hydroxyquinolinato)aluminium, bis(4,6-difluorophenylpyridinato-N,C2)picolinatoiridium, bis(4,6-difluorophenyridinato) tetrakis (1-pyrazolyl)borate iridium, bis(2-methyldibenzo[f,h]quinoxaline) (acetylacetonate) iridium or tris(2-phenylpyridine)iridium.

Host material for light-emitting layer is one or two of 1,1-bis[4-(N,N-di(p-tolyl)amino)phenyl]cyclohexane (TAPC), N,N'-bis(3-methylphenyl)-N,N'-diphenyl-4,4'-benzidine (TPD), 4,4',4"-tris(carbazol-9-yl)-triphenylamine (TCTA), N,N'-di-[(1-naphthalenyl)-N,N'-diphenyl]- (4.4'-biphenyl)- 4,4'- diamine (NPB), 2-(4-tert-butylphenyl)-5-(4-biphenyl)-1,3,4-oxadiazole (PBD), tris(8-hydroxyquinolinato) aluminium (Alq₃), 4,7-diphenyl-1,10-phenanthroline (Bphen), 1,2,4-triazole derivatives (such as TAZ) and N-phenyl benzimidazole (TPBI).

Preferably, thickness of light-emitting layer is in the range of 2-50nm. More preferably, thickness of light-emitting layer is 20nm.

Electron transportation layer is deposited on the light-emitting layer. Preferably, material for electron transportation layer is 2-(4-tert-butylphenyl)-5-(4-biphenyl)-1,3,4-oxadiazole (PBD), tris(8-hydroxyquinolinato)aluminium (Alq₃), 4,7-diphenyl-1,10-phenanthroline (Bphen), 1,2,4-triazole derivatives (such as TAZ) or N-phenyl benzimidazole (TPBI). More preferably, material for electron transportation layer is 4,7-diphenyl-1,10-phenanthroline.

Preferably, thickness of electron transportation layer is in the range of 40-80nm. More preferably, thickness of electron transportation layer is 60nm.

Preferably, material for electron injecting layer is LiF, CaF₂ or NaF. More preferably, electron injecting layer is LiF.

Preferably, thickness of electron injecting layer is in the range of 0.5-5nm.More preferably, thickness of electron injecting layer is 0.7nm.

Preferably, material for cathode layer is silver (Ag), aluminium (Al), platinum (Pt) or gold (Au).More preferably, cathode layer is aluminium.

Preferably, thickness of cathode layer is in the range of 80-250nm. More preferably, thickness of cathode layer is 150nm.

The present invention provides method for preparing organic electroluminescent device having ternary doped hole transportation layer, which comprises the following benefits:
(1) In the present invention, material for the ternary doped hole transportation layer is a mixed material made by doping cerium salt and hole transportation material into metal compound. Metal compound can increase the work-function, and decrease hole injecting barrier. P-doping formed by doping cesium salt is of benefit to hole injection and transportation. The doped hole transportation material can further increase hole transportation rate and film quality (small organic molecules have relatively good film-forming properties), thereby increasing the probability of recombining of excitons in light-emitting layer.
(2) Compared with the prior art that doping p-type material in a tiny amount (doping percentage is 0.5%-2%) into hole transportation material, the ternary doped hole transportation layer of the present invention is predominantly a metal compound. The process difficulty and manufacturing costs are reduced, facilitating industrial production and commercial applications in the future.

### BRIEF DESCRIPTION OF THE DRAWINGS

Fig. 1 is a structural view of the organic electroluminescent device of the present invention. Units 1-6 are: conductive anode substrate, ternary doped hole transportation layer, light-emitting layer, electron transportation layer, electron injecting layer and metallic cathode layer.
Fig. 2 shows current efficiency-density curves of the organic electroluminescent device having ternary doped hole transportation layer (ITO/ (ZnO:NPB:CsF)/Alq₃/Bphen/LiF/Al) prepared from Example 1, as well as the conventional organic electroluminescent device (ITO/MoO₃/NPB/Alq₃/ Bphen/LiF/Al).

### DETAILED DESCRIPTION OF ILLUSTRATED EMBODIMENTS

The details of some preferred embodiments are set forth in the accompanying drawings and description below. It will be apparent to those skilled in the art that many changes and substitutions can be made to the preferred embodiment s herein described without departing from the spirit and scope of the present invention as defined by the appended claims. Consequently, these changes and substitutions are within the scope of the present invention.

One aspect of the present invention is to provide organic electroluminescent device having ternary doped hole transportation layer, comprising conductive anode substrate, ternary doped hole transportation layer, light-emitting layer, electron transportation layer, electron injecting layer and cathode layer stacked in sequence, wherein material for the ternary doped hole transportation layer is a mixed material made by doping cerium salt and hole transportation material into metal compound.

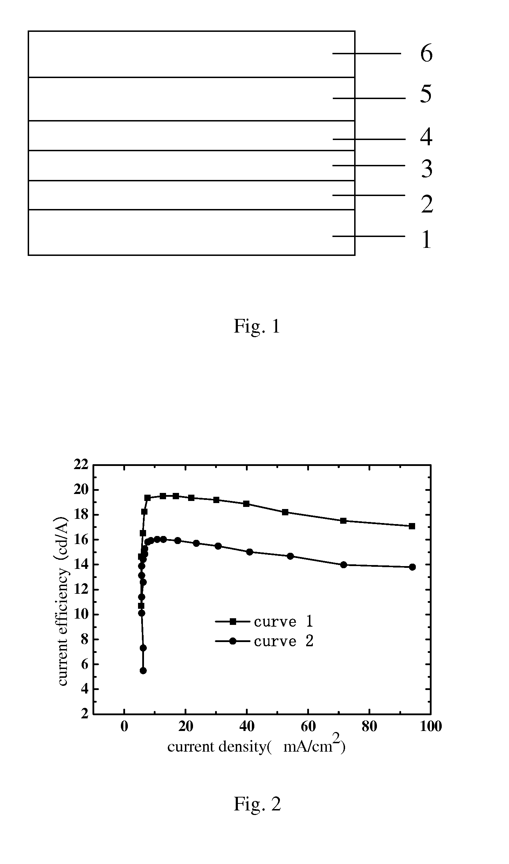

Fig. 1 is a structural view of the organic electroluminescent device of the present invention. Units 1-6 are: conductive anode substrate, ternary doped hole transportation layer, light-emitting layer, electron transportation layer, electron injecting layer and metallic cathode layer.

Conductive anode substrate can be conductive glass substrate selected from indium tin oxide glass (ITO), fluorine doped tin oxide glass (FTO), aluminium doped zinc oxide (AZO) and indium doped zinc oxide (IZO).

Ternary doped hole transportation layer is a mixed material predominantly comprising metal compound. The mixed material is formed by doping cesium salt and hole transportation material into metal compound. Ternary doped hole transportation layer can be prepared as follows: doping cesium salt and hole transportation material into metal compound to form mixed material by e-beam deposition. Ternary doped hole transportation layer is deposited on the conductive anode substrate.

Metal compound is metallic oxide (such as, zinc oxide (ZnO) or titanium dioxide (TiO₂)) or metallic sulfide (such as, zinc sulfide (ZnS) or lead sulfide (PbS)). In addition, metallic oxide or metallic sulfide have melting point of 1800°C or below, and can be processed by thermal vapor deposition method. The crystals of the metallic oxide or metallic sulfide are colorless or light in color. Herein, ZnO, TiO₂ and ZnS are preferred.

Cerium salt is cesium azide (CsN₃), cesium fluoride (CsF), cesium carbonate (Cs₂CO₃) or cesium oxide (Cs₂O). Doping mass percentage of the cerium salt is in the range of 1%-5%.

Hole transportation material is 1,1-bis[4-(N,N-di(p-tolyl)amino)phenyl] cyclohexane (TAPC), N,N'-bis(3-methylphenyl)-N,N'-diphenyl-4,4'-benzidine (TPD), 4,4',4"-tris(carbazol-9-yl)-triphenylamine (TCTA) or N,N'-di-[(1-naphthalenyl)-N,N'-diphenyl]- (4.4'-biphenyl)- 4,4'- diamine (NPB). Doping percentage of the hole transportation material is in the range of 10 wt%-40 wt%.

Thickness of the ternary doped hole transportation layer is in the range of 20-60nm.

In the material of ternary doped hole transportation layer, metal compound can increase the work-function, and decrease hole injecting barrier. P-doping formed by doping cesium salt is of benefit to hole injection and transportation. The doped hole transportation material can further increase hole transportation rate and film quality (small organic molecules have relatively good film-forming properties), thereby increasing the probability of recombining of excitons in light-emitting layer.

Compared with the prior art that doping p-type material in a tiny amount (doping percentage is 0.5%-2%) into hole transportation material, the ternary doped hole transportation layer of the present invention is predominantly a metal compound. The process difficulty and manufacturing costs are reduced, facilitating industrial production and commercial applications in the future.

Light-emitting layer is deposited on the ternary doped hole transportation layer.

Material for light-emitting layer is at least one of 4-(dicyanomethylene)-2-tert-butyl-6-(1,1,7,7-tetramethyljulolidin-9-yl-vinyl)-4h-pyran (DCJTB), tris(8-hydroxyquinolinato)aluminium (Alq₃), bis(4,6-difluorophenylpyridinato-N,C2)picolinatoiridium (FIrpic), bis(4,6-difluorophenyridinato)tetrakis(1-pyrazolyl)borate iridium (FIr6), bis(2-methyldibenzo[f,h]quinoxaline) (acetylacetonate) iridium (Ir(MDQ)₂(acac)) and tris(2-phenylpyridine)iridium (Ir(ppy)3); or, material for light-emitting layer is a mixed material comprising host material and guest material, the host material is doped with guest material, and doping percentage of guest material is in the range of 1 wt%-20 wt%.

Guest material for light-emitting layer is 4-(dicyanomethylene)-2-tert-butyl-6-(1,1,7,7-tetramethyljulolidin-9-yl-vinyl)-4h-pyran, tris(8-hydroxyquinolinato)aluminium, bis(4,6-difluorophenylpyridinato-N,C2)picolinatoiridium, bis(4,6-difluorophenyridinato) tetrakis (1-pyrazolyl)borate iridium, bis(2-methyldibenzo[f,h]quinoxaline) (acetylacetonate) iridium or tris(2-phenylpyridine)iridium.

Host material for light-emitting layer is one or two of 1,1-bis[4-(N,N-di(p-tolyl)amino) phenyl]cyclohexane (TAPC), N,N'-bis(3-methylphenyl)-N,N'-diphenyl-4,4'-benzidine (TPD), 4,4',4"-tris(carbazol-9-yl)-triphenylamine (TCTA), N,N'-di-[(1-naphthalenyl)-N,N'-diphenyl]- (4.4'-biphenyl)- 4,4'- diamine (NPB), 2-(4-tert-butylphenyl)-5-(4-biphenyl)-1,3,4-oxadiazole (PBD), tris(8-hydroxyquinolinato) aluminium (Alq₃), 4,7-diphenyl-1,10-phenanthroline (Bphen), 1,2,4-triazole derivatives (such as TAZ) and N-phenyl benzimidazole (TPBI).

Thickness of light-emitting layer is in the range of 2-50nm.

Electron transportation layer is deposited on the light-emitting layer. Material for electron transportation layer is 2-(4-tert-butylphenyl)-5-(4-biphenyl)-1,3,4-oxadiazole (PBD), tris(8-hydroxyquinolinato)aluminium (Alq₃), 4,7-diphenyl-1,10-phenanthroline (Bphen), 1,2,4-triazole derivatives (such as TAZ) or N-phenyl benzimidazole (TPBI).

Thickness of electron transportation layer is in the range of 40-80nm.

Material for electron injecting layer is LiF, CaF₂ or NaF.

Thickness of electron injecting layer is in the range of 0.5-5nm.

Material for cathode layer is silver (Ag), aluminium (Al), platinum (Pt) or gold (Au).

Thickness of cathode layer is in the range of 80-250nm.

Another aspect of the present invention is to provide method for preparing organic electroluminescent device having ternary doped hole transportation layer, which comprises the following steps:
(1) ultrasonically cleaning conductive anode substrate, then treating the conductive anode substrate with oxygen plasma;
(2) vapor depositing ternary doped hole transportation layer on the surface of the plasma-treated conductive anode substrate by e-beam deposition, wherein material for the ternary doped hole transportation layer is a mixed material made by doping cerium salt and hole transportation material into metal compound;
(3) vapor depositing light-emitting layer, electron transportation layer, electron injecting layer and cathode layer successively on the surface of the ternary doped hole transportation layer; and
the organic electroluminescent device is obtained after completion of the above process.

In step (1), organic pollutant on the surface of conductive anode substrate can be removed by ultrasonically cleaning.

Conductive anode substrate can be conductive glass substrate selected from indium tin oxide glass (ITO), fluorine doped tin oxide glass (FTO), aluminium doped zinc oxide (AZO) and indium doped zinc oxide (IZO).

Conductive anode substrate is ultrasonically cleaned successively with detergent, deionized water, acetone, ethanol and isopropanol for 15 min.

After cleaning, the conductive anode substrate is treated with oxygen plasma. The oxygen plasma treatment is carried out for 5-15 min at a power of from 10W to 50W.

In step (2), ternary doped hole transportation layer is deposited on the surface of the oxygen plasma-treated conductive anode substrate by e-beam deposition.

Ternary doped hole transportation layer is a mixed material predominantly comprising metal compound. The mixed material is formed by doping cesium salt and hole transportation material into metal compound.

Metal compound is metallic oxide (such as, zinc oxide (ZnO) or titanium dioxide (TiO₂)) or metallic sulfide (such as, zinc sulfide (ZnS) or lead sulfide (PbS)). In addition, metallic oxide or metallic sulfide have melting point of 1800°C or below, and can be processed by thermal vapor deposition method. The crystals of the metallic oxide or metallic sulfide are colorless or light in color. Herein, ZnO, TiO₂ and ZnS are preferred.

Cerium salt is cesium azide (CsN₃), cesium fluoride (CsF), cesium carbonate (Cs₂CO₃) or cesium oxide (Cs₂O). Doping mass percentage of the cerium salt is in the range of 1%-5%.

Hole transportation material is 1,1-bis[4-(N,N-di(p-tolyl)amino)phenyl] cyclohexane (TAPC), N,N'-bis(3-methylphenyl)-N,N'-diphenyl-4,4'-benzidine (TPD), 4,4',4"-tris(carbazol-9-yl)-triphenylamine (TCTA) or N,N'-di-[(1-naphthalenyl)-N,N'-diphenyl]-(4.4'-biphenyl)- 4,4'- diamine (NPB). Doping percentage of the hole transportation material is in the range of 10 wt%-40 wt%.

Thickness of the ternary doped hole transportation layer is in the range of 20-60nm.

In the material of ternary doped hole transportation layer, metal compound can increase the work-function, and decrease hole injecting barrier. P-doping formed by doping cesium salt is of benefit to hole injection and transportation. The doped hole transportation material can further increase hole transportation rate and film quality (small organic molecules have relatively good film-forming properties), thereby increasing the probability of recombining of excitons in light-emitting layer.

Compared with the prior art that doping p-type material in a tiny amount (doping percentage is 0.5%-2%) into hole transportation material, the ternary doped hole transportation layer of the present invention is predominantly a metal compound. The process difficulty and manufacturing costs are reduced, facilitating industrial production and commercial applications in the future.

In step (3), light-emitting layer, electron transportation layer, electron injecting layer and cathode layer are successively vapor deposited to obtain the desire organic electroluminescent device.

Light-emitting layer is deposited on the ternary doped hole transportation layer.

Material for light-emitting layer is at least one of 4-(dicyanomethylene)-2-tert-butyl-6- (1,1,7,7-tetramethyljulolidin-9-yl-vinyl)-4h-pyran (DCJTB), tris(8-hydroxyquinolinato)aluminium (Alq₃), bis(4,6-difluorophenylpyridinato-N,C2)picolinatoiridium (FIrpic), bis(4,6-difluorophenyridinato)tetrakis(1-pyrazolyl)borate iridium (FIr6), bis(2-methyldibenzo[f,h]quinoxaline) (acetylacetonate) iridium (Ir(MDQ)₂(acac)) and tris(2-phenylpyridine)iridium; or

Material for light-emitting layer is a mixed material comprising host material and guest material, the host material is doped with guest material, and doping percentage of guest material is in the range of 1 wt%-20 wt%.

Guest material for light-emitting layer is 4-(dicyanomethylene)-2-tert-butyl-6-(1,1,7,7-tetramethyljulolidin-9-yl-vinyl)-4h-pyran, tris(8-hydroxyquinolinato)aluminium, bis(4,6-difluorophenylpyridinato-N,C2)picolinatoiridium, bis(4,6-difluorophenyridinato) tetrakis (1-pyrazolyl)borate iridium, bis(2-methyldibenzo[f,h]quinoxaline) (acetylacetonate) iridium or tris(2-phenylpyridine)iridium.

Host material for light-emitting layer is one or two of 1,1-bis[4-(N,N-di(p-tolyl)amino)phenyl]cyclohexane (TAPC), N,N'-bis(3-methylphenyl)-N,N'-diphenyl-4,4'-benzidine (TPD), 4,4',4"-tris(carbazol-9-yl)-triphenylamine (TCTA), N,N'-di-[(1-naphthalenyl)-N,N'-diphenyl]- (4.4'-biphenyl)- 4,4'- diamine (NPB), 2-(4-tert-butylphenyl)-5-(4-biphenyl)-1,3,4-oxadiazole (PBD), tris(8-hydroxyquinolinato) aluminium (Alq3), 4,7-diphenyl-1,10-phenanthroline (Bphen), 1,2,4-triazole derivatives (such as TAZ) and N-phenyl benzimidazole (TPBI).

Thickness of light-emitting layer is in the range of 2-50nm.

Electron transportation layer is deposited on the light-emitting layer. Material for electron transportation layer is 2-(4-tert-butylphenyl)-5-(4-biphenyl)-1,3,4-oxadiazole (PBD), tris(8-hydroxyquinolinato)aluminium (Alq₃), 4,7-diphenyl-1,10-phenanthroline (Bphen), 1,2,4-triazole derivatives (such as TAZ) or N-phenyl benzimidazole (TPBI).

Thickness of electron transportation layer is in the range of 40-80nm.

Material for electron injecting layer is LiF, CaF₂ or NaF.

Thickness of electron injecting layer is in the range of 0.5-5nm.

Material for cathode layer is silver (Ag), aluminium (Al), platinum (Pt) or gold (Au).

Thickness of cathode layer is in the range of 80-250nm.

### Example 1

A organic electroluminescent device having ternary doped hole transportation layer was prepared as follows.
(1) ITO was ultrasonically cleaned successively with detergent, deionized water, acetone, ethanol and isopropanol for 15 min to remove the organic pollutant on the surface of ITO. Then the cleaned ITO was treated with oxygen plasma for 10 min at a power of 35W.
(2) Ternary doped hole transportation layer was vapor deposited on the surface of the oxygen plasma-treated ITO by e-beam deposition. The ternary doped hole transportation layer was formed by doping cesium salt and hole transportation material into metallic oxide. The metallic oxide was ZnO, cesium salt was CsF, doping percentage of CsF was 2 wt%, hole transportation material was NPB, doping percentage of NPB was 30 wt%, thickness of the ternary doped hole transportation layer was 50 nm.
(3) Light-emitting layer was firstly vapor deposited. Light-emitting layer was Alq₃, doping percentage of light-emitting layer was 10 wt%, thickness of light-emitting layer was 20 nm. Then electron transportation layer was vapor deposited. The electron transportation layer was formed by depositing electron transportation material Bphen on the light-emitting layer. Thickness of the electron transportation layer was 60 nm. Subsequently, electron injecting layer and cathode layer were vapor deposited. Electron injecting layer was LiF, thickness of electron injecting layer was 0.7 nm. Cathode layer was Al, thickness of cathode layer was 150 nm. Finally, the desired organic electroluminescent device was obtained.

The organic electroluminescent device having ternary doped hole transportation layer of the Example 1 has a structure of ITO/ (ZnO:NPB:CsF)/Alq₃/Bphen/LiF/Al.

### Example 2

A organic electroluminescent device having ternary doped hole transportation layer was prepared as follows.
(1) AZO was ultrasonically cleaned successively with detergent, deionized water, acetone, ethanol and isopropanol for 15 min to remove the organic pollutant on the surface of AZO. Then the cleaned AZO was treated with oxygen plasma for 5min at a power of 50 W.
(2) Ternary doped hole transportation layer was vapor deposited on the surface of the oxygen plasma-treated AZO by e-beam deposition. The ternary doped hole transportation layer was formed by doping cesium salt and hole transportation material into metallic sulfide. The metallic sulfide was ZnS, cesium salt was Cs₂CO₃, doping percentage of Cs₂CO₃ was 1 wt%, hole transportation material was TCTA, doping percentage of TCTA was 40 wt%, thickness of the ternary doped hole transportation layer was 60 nm.
(3) Light-emitting layer was firstly vapor deposited. Light-emitting layer was TCTA doped with Firpic, doping percentage of Firpic was 20 wt%, thickness of light-emitting layer was 15 nm. Then electron transportation layer was vapor deposited. The electron transportation layer was formed by depositing electron transportation material TPBI on the light-emitting layer. Subsequently, electron injecting layer and cathode layer were vapor deposited. Electron injecting layer was NaF, thickness of electron injecting layer was 0.5 nm. Cathode layer was Ag, thickness of cathode layer was 80 nm. Finally, the desired organic electroluminescent device was obtained.

The organic electroluminescent device having ternary doped hole transportation layer of the Example 1 has a structure of AZO/ (ZnS: TCTA: Cs₂CO₃)/ (TCTA: Firpic)/ TPBI/NaF/Ag.

### Example 3

A organic electroluminescent device having ternary doped hole transportation layer was prepared as follows.
(1) IZO was ultrasonically cleaned successively with detergent, deionized water, acetone, ethanol and isopropanol for 15 min to remove the organic pollutant on the surface of IZO. Then the cleaned IZO was treated with oxygen plasma for 15 min at a power of 10 W.
(2) Ternary doped hole transportation layer was vapor deposited on the surface of the oxygen plasma-treated IZO by e-beam deposition. The ternary doped hole transportation layer was formed by doping cesium salt and hole transportation material into metallic oxide. The metallic oxide was TiO2, cesium salt was Cs₂O,̅ doping percentage of Cs₂O was 5 wt%, hole transportation material was TAPC, doping percentage of TAPC was 10 wt%, thickness of the ternary doped hole transportation layer was 20 nm.
(3) Light-emitting layer was firstly vapor deposited. Light-emitting layer was TPBI doped with Ir(ppy)₃, doping percentage of Ir(ppy)₃ was 10 wt%, thickness of light-emitting layer was 10 nm. Then electron transportation layer was vapor deposited. The electron transportation layer was formed by depositing electron transportation material PBDI on the light-emitting layer. Subsequently, electron injecting layer and cathode layer were vapor deposited. Electron injecting layer was CaF₂, thickness of electron injecting layer was 5 nm. Cathode layer was Pt, thickness of cathode layer was 250 nm. Finally, the desired organic electroluminescent device was obtained.

The organic electroluminescent device having ternary doped hole transportation layer of the Example 3 has a structure of IZO/ (TiO₂: TAPC: Cs₂O)/ (TPBI: Ir(ppy)₃)/ PBDI/CaF/Pt.

### Example 4

A organic electroluminescent device having ternary doped hole transportation layer was prepared as follows.
(1) FTO was ultrasonically cleaned successively with detergent, deionized water, acetone, ethanol and isopropanol for 15 min to remove the organic pollutant on the surface of FTO. Then the cleaned FTO was treated with oxygen plasma for 8min at a power of 40 W.
(2) Ternary doped hole transportation layer was vapor deposited on the surface of the oxygen plasma-treated FTO by e-beam deposition. The ternary doped hole transportation layer was formed by doping cesium salt and hole transportation material into metallic sulfide. The metallic sulfide was PbS, cesium salt was CsN₃, doping percentage of CsN₃ was 1 wt%, hole transportation material was PBD, doping percentage of PBD was 30 wt%, thickness of the ternary doped hole transportation layer was 60 nm.
(3) Light-emitting layer was firstly vapor deposited. Light-emitting layer was TAPC doped with Ir(MDQ)₂(acac), doping percentage of Ir(MDQ)₂(acac) was 1 wt%, thickness of light-emitting layer was 2 nm. Then electron transportation layer was vapor deposited. The electron transportation layer was formed by depositing electron transportation material TAZ on the light-emitting layer. Subsequently, electron injecting layer and cathode layer were vapor deposited. Electron injecting layer was LiF, thickness of electron injecting layer was 1 nm. Cathode layer was Au, thickness of cathode layer was 100 nm. Finally, the desired organic electroluminescent device was obtained.

The organic electroluminescent device having ternary doped hole transportation layer of the Example 4 has a structure of FTO/ (PbS: PBD: CsN₃)/ (TAPC: Ir(MDQ)₂(acac))/ TAZ/LiF/Au.

### Example 5

A organic electroluminescent device having ternary doped hole transportation layer was prepared as follows.
(1) ITO was ultrasonically cleaned successively with detergent, deionized water, acetone, ethanol and isopropanol for 15 min to remove the organic pollutant on the surface of ITO. Then the cleaned ITO was treated with oxygen plasma for 10 min at a power of 30W.
(2) Ternary doped hole transportation layer was vapor deposited on the surface of the oxygen plasma-treated ITO by e-beam deposition. The ternary doped hole transportation layer was formed by doping cesium salt and hole transportation material into metallic oxide. The metallic oxide was ZnO, cesium salt was Cs₂CO₃, doping percentage of Cs₂CO₃ was 2 wt%, hole transportation material was TAPC, doping percentage of TAPC was 30 wt%, thickness of the ternary doped hole transportation layer was 50 nm.
(3) Light-emitting layer was firstly vapor deposited. Light-emitting layer was DCJTB, doping percentage of light-emitting layer was 10 wt%, thickness of light-emitting layer was 50 nm. Then electron transportation layer was vapor deposited. The electron transportation layer was formed by depositing electron transportation material Bphen on the light-emitting layer. Subsequently, electron injecting layer and cathode layer were vapor deposited. Electron injecting layer was NaF, thickness of electron injecting layer was 4 nm. Cathode layer was Al, thickness of cathode layer was 180 nm. Finally, the desired organic electroluminescent device was obtained.

The organic electroluminescent device having ternary doped hole transportation layer of the Example 5 has a structure of ITO/ (ZnO: TAPC: Cs₂CO₃)/ DCJTB/Bphen/NaF/Al.

The testing instruments employed in the above five embodiments encompass: high vacuum film coating device (Shenyang Scientific Instrument Development Center Co., Ltd. China. voltage<1×10-3Pa); current-voltage tester (Keithley Instruments Inc. US. model: 2602), electroluminescent spectrometer (Photo Research, Inc. US. model: PR650), and screen luminance meter (Beijing Normal University, China. model: ST-86LA).

Example illustrating the effects

Fig. 2 shows current efficiency-density curves of the organic electroluminescent device having ternary doped hole transportation layer (ITO/ (ZnO:NPB:CsF)/Alq₃/Bphen/LiF/Al) prepared from Example 1, as well as the conventional organic electroluminescent device (ITO/MoO₃/NPB/Alq₃/ Bphen/LiF/Al).

It can be seen from Fig. 2 that the maximum current efficiency (19.5 cd/A) of the embodiment of Example 1 is greater than that of conventional OLED (16.1 cd/A). It indicates that the structure of ternary doped p-type hole transportation layer decrease barrier between anode and light-emitting layer, which is of benefit to hole injection. Meanwhile, hole transportation rate is improved, thereby increasing probability of recombining of holes and electrons, and improving efficiency of light emission.

While the invention has been described in connection with what are presently considered to be the most practical and preferred embodiments, it is to be understood that the invention is not to be limited to the disclosed embodiments, but on the contrary, is intended to cover various modifications and equivalent arrangements included within the spirit and scope of the invention.

## Claims

1. A organic electroluminescent device having ternary doped hole transportation layer, comprising:
conductive anode substrate,
ternary doped hole transportation layer,
light-emitting layer,
electron transportation layer,
electron injecting layer, and
cathode layer stacked in sequence,
wherein material for the ternary doped hole transportation layer is a mixed material made by doping cerium salt and hole transportation material into metal compound.

2. The organic electroluminescent device according to claim 1, wherein the metal compound is metallic oxide or metallic sulfide, the metallic oxide is zinc oxide or titanium dioxide; the metallic sulfide is zinc sulfide or lead sulfide, the cesium salt is cesium azide, cesium fluoride, cesium carbonate or cesium oxide.

3. The organic electroluminescent device according to claim 1, wherein the hole transportation material is 1,1-bis[4-(N,N-di(p-tolyl)amino)phenyl]cyclohexane, N,N'-bis(3-methylphenyl)-N,N'-diphenyl-4,4'-benzidine, 4,4',4"-tris(carbazol-9-yl)-triphenylamine or N,N'-di-[(1-naphthalenyl)-N,N'-diphenyl]- (4.4'-biphenyl)- 4,4'- diamine.

4. The organic electroluminescent device according to claim 1, wherein doping percentage of the cesium salt is in the range of 1 wt%-5 wt%, doping percentage of the hole transportation material is in the range of 10 wt%-40 wt%.

5. The organic electroluminescent device according to claim 1, material for light-emitting layer is:
at least one of 4-(dicyanomethylene)-2-tert-butyl-6-(1,1,7,7-tetramethyljulolidin-9-yl-vinyl)-4h-pyran, tris(8-hydroxyquinolinato)aluminium, bis(4,6-difluorophenylpyridinato-N,C2)picolinatoiridium, bis(4,6-difluorophenyridinato)tetrakis(1-pyrazolyl)borate iridium, bis(2-methyldibenzo[f,h]quinoxaline) (acetylacetonate) iridium and tris(2-phenylpyridine)iridium; or
material for the light-emitting layer is a mixed material comprising host material and guest material, the host material is doped with guest material, wherein :
the guest material is 4-(dicyanomethylene)-2-tert-butyl-6-(1,1,7,7-tetramethyljulolidin-9-yl-vinyl)-4h-pyran, tris(8-hydroxyquinolinato)aluminium, bis(4,6-difluorophenylpyridinato-N,C2)picolinatoiridium, bis(4,6-difluorophenyridinato)tetrakis (1-pyrazolyl)borate iridium, bis(2-methyldibenzo[f,h]quinoxaline) (acetylacetonate) iridium or tris(2-phenylpyridine)iridium;
the host material is one or two of 1,1-bis[4-(N,N-di(p-tolyl)amino)phenyl]cyclohexane, N,N'-bis(3-methylphenyl)-N,N'-diphenyl-4,4'-benzidine, 4,4',4"-tris(carbazol-9-yl)-triphenylamine, N,N'-di-[(1-naphthalenyl)-N,N'-diphenyl]-(4.4'-biphenyl)-4,4'-diamine, 2-(4-tert-butylphenyl)-5-(4-biphenyl)-1,3,4-oxadiazole, tris(8-hydroxyquinolinato)aluminium, 4,7-diphenyl-1,10-phenanthroline, 1,2,4-triazole derivatives and N-phenyl benzimidazole.

6. The organic electroluminescent device according to claim 1, wherein material for the electron transportation layer is 2-(4-tert-butylphenyl)-5-(4-biphenyl)-1,3,4-oxadiazole, tris(8-hydroxyquinolinato)aluminium, 4,7-diphenyl-1,10-phenanthroline, 1,2,4-triazole derivatives or N-phenyl benzimidazole.

7. The organic electroluminescent device according to claim 1, wherein material for the electron injecting layer is LiF, CaF₂ or NaF.

8. The organic electroluminescent device according to claim 1, wherein the conductive anode substrate is indium tin oxide glass, fluorine doped tin oxide glass, aluminium doped zinc oxide or indium doped zinc oxide.

9. The organic electroluminescent device according to claim 1, wherein cathode layer is silver, aluminium, platinum or gold.

10. A method for preparing organic electroluminescent device having ternary doped hole transportation layer according to claim 1, which comprises the following steps:
(1) ultrasonically cleaning conductive anode substrate, then treating the conductive anode substrate with oxygen plasma;
(2) vapor depositing ternary doped hole transportation layer on the surface of the plasma-treated conductive anode substrate by e-beam deposition, wherein material for the ternary doped hole transportation layer is a mixed material made by doping cerium salt and hole transportation material into metal compound;
(3) vapor depositing light-emitting layer, electron transportation layer, electron injecting layer and cathode layer successively on the surface of the ternary doped hole transportation layer; and
the organic electroluminescent device is obtained after completion of the above process.
